# EUROPEAN PATENT APPLICATION

(11) **EP 4 518 606 A1**
(43) Date of publication of application: **05.03.2025**
(21) Application number: 24784104.2
(22) Date of filing: 26.03.2024
(51) Int. Cl.: H10B 12/00

(54) **SEMICONDUCTOR STRUCTURE AND MANUFACTURING METHOD THEREFOR**

(30) Priority: 03.04.2023 CN 202310364909
(71) Applicant: CXMT Corporation, Hefei City, Anhui Province 230601 (CN)
(72) Inventor: HAN, Qinghua, Hefei, Anhui 230601 (CN); CAO, Kanyu, Hefei, Anhui 230601 (CN); LIU, Xiang, Hefei, Anhui 230601 (CN)
(74) Representative: Gulde & Partner
(86) International application number: PCT/CN2024/083705
(87) International publication number: WO 2024/208019

(57) **Abstract**

The present disclosure relates to a semiconductor structure and a method for manufacturing the same. The semiconductor structure includes a substrate, a plurality of word lines, and a plurality of repeating units. The plurality of word lines are spaced apart in parallel on the substrate, the plurality of word lines extending along a first direction; the plurality of repeating units are respectively located in gaps between adjacent word lines, each of the plurality of repeating units including an active structure and an air gap structure arranged side by side in a second direction. The second direction intersects with the first direction. The semiconductor structure can realize higher storage density and improve production yield and electrical properties.

## Description

The present disclosure claims priority to Chinese Patent Application No. 202310364909.4 filed with China National Intellectual Property Administration on April 3, 2024, and entitled "Semiconductor Structure and Method For Manufacturing Same", the content of which is incorporated herein by reference in its entirety.

### TECHNICAL FIELD

The present disclosure relates to the field of semiconductor technologies, and in particular, relates to a semiconductor structure and a method for manufacturing the same.

### BACKGROUND

As the integration density of semiconductor devices continues to develop towards higher levels, research has begun on the arrangement of transistors in the semiconductor structure and how to reduce the size of the individual functional devices in the semiconductor structure.

In the related art, a dynamic random access memory (DRAM) memory cell based on a saddle-fin transistor occupies an area of 6F² (where F represents the smallest process size available under the given process conditions). Scaling down the DRAM of this structure proportionally (e.g., to 15 nm and below) may present significant challenges, such as proximity gate effect, high capacitance of bit lines, high contact resistance of nodes, and high contact resistance of bit lines, which adversely affect the electrical properties of the DRAM.

Therefore, how to increase the storage density of devices while avoiding adverse impacts on their electrical properties remains an urgent problem that needs to be solved currently.

### SUMMARY

Based on this, there is a need to provide a semiconductor structure and a method for manufacturing the same to address the shortcomings of the prior art.

In one aspect, the present disclosure provides a semiconductor structure according to some embodiments. The semiconductor structure includes:
a substrate;
a plurality of word lines spaced apart in parallel on the substrate, the plurality of word lines extending along a first direction;
and a plurality of repeating units respectively located in gaps between adjacent word lines, each of the plurality of repeating units including an active structure and an air gap structure arranged side by side in a second direction, and the second direction intersecting with the first direction.

In some embodiments, the active structure includes a plurality of active pillars spaced apart in the first direction and isolation pillars located between adjacent active pillars; and
the air gap structure includes an air cavity extending along the first direction and an encapsulating layer surrounding and enclosing the air cavity, two opposite sidewalls of the encapsulating layer in the second direction covering a sidewall of an adjacent active structure and a sidewall of an adjacent word line, respectively.

In some embodiments, a shape of an orthographic projection of each of the active pillars on the substrate is an irregular quadrilateral.

In some embodiments, the air cavity is a strip-shaped air cavity; orthographic projection shapes of each of the active pillars and each of the isolation pillars on the substrate are both rectangles.

In some embodiments, the active structure and the air gap structure are equal in size in the second direction.

In some embodiments, a distance between adjacent active pillars in the first direction is equal to a distance between adjacent active pillars in the second direction.

In some embodiments, the active pillars in the plurality of repeating units are arranged in a square close-packed manner;
the semiconductor structure further includes:
a plurality of landing pads respectively disposed on top surfaces of corresponding active pillars; and
a plurality of memory elements respectively disposed on top surfaces of corresponding landing pads.

In some embodiments, the active pillars in the plurality of repeating units are arranged in a hexagonal close-packed manner;
the semiconductor structure further includes:
a plurality of memory elements respectively disposed on top surfaces of corresponding active pillars.

In some embodiments, the repeating unit includes a plurality of first repeating units and a plurality of second repeating units alternately arranged in the first direction as well as isolation units located between any of the first repeating units and second repeating units adjacent thereto, where
each of the plurality of first repeating units includes a first active structure and a first air gap structure arranged side by side in the second direction;
each of the plurality of second repeating units includes a second air gap structure and a second active structure arranged side by side in the second direction;
the first active structure and the second air gap structure are alternately arranged in the first direction; and
the second active structure and the first air gap structure are alternately arranged in the first direction.

In some embodiments, an orthographic projection of the first active structure on the substrate and an orthographic projection of a second active structure adjacent to the first active structure in the first direction on the substrate are two sub-regions of a same rectangle, respectively.

In some embodiments, a plurality of the first active structures are arranged in rows in the second direction and a plurality of the second active structures are arranged in rows in the second direction, where
the first active structures in adjacent rows and the second active structures in adjacent rows are arranged in columns in a third direction, the third direction intersecting with both the first direction and the second direction.

In some embodiments, a distance between the first active structure and a first active structure adjacent to the first active structure in the second direction is a first distance; and
a distance between the first active structure and a second active structure adjacent to the first active structure in the third direction is a second distance,
where the second distance is equal to the first distance.

In some embodiments, orthographic projections of the first active structure and the second air gap structure on the substrate have a same shape; and
orthographic projections of the second active structure and the first air gap structure on the substrate have a same shape.

In some embodiments, shapes of the orthographic projections of the first active structure and the second air gap structure on the substrate are a first shape; shapes of the orthographic projections of the second active structure and the first air gap structure on the substrate are a second shape, where
both the first shape and the second shape are triangles or trapezoids;
or, one of the first shape and the second shape is a triangle and the other is a trapezoid.

In some embodiments, the semiconductor structure further includes:
gate oxide layers located between the repeating units and word lines adjacent to the repeating units.

In some embodiments, the semiconductor structure further includes:
a plurality of bit lines spaced apart in parallel on the substrate and located between the substrate and the repeating units, the plurality of bit lines extending along the second direction (X) and being correspondingly connected to the plurality of active structures arranged along the second direction.

In another aspect, the present disclosure further provides a method for manufacturing a semiconductor structure according to some embodiments. The method for manufacturing a semiconductor structure includes:
providing a substrate; and
forming, on the substrate, a plurality of repeating units spaced apart in parallel and word lines located between adjacent repeating units, where the word lines extend along a first direction; each of the plurality of repeating units comprises an active structure and an air gap structure arranged side by side in a second direction; the second direction intersects with the first direction.

In some embodiments, the forming, on the substrate, a plurality of repeating units spaced apart in parallel and word lines located between the adjacent repeating units includes:
forming a plurality of initial active structures spaced apart in parallel on the substrate, the plurality of initial active structures extending along the second direction;
forming initial isolation structures in gaps between adjacent initial active structures;
patterning the initial active structures and the initial isolation structures to form intermediate active structures, intermediate isolation structures, and a plurality of word line trenches, the plurality of word line trenches extending along the first direction;
forming the word lines in the plurality of word line trenches;
patterning the intermediate active structures and the intermediate isolation structures to form, between adjacent word lines, a plurality of active pillars spaced apart in the first direction, isolation pillars located between adjacent active pillars, and an air cavity located on one side of the plurality of active pillars and the isolation pillars close to an adjacent word line, where the active pillars and the isolation pillars jointly form the active structure and the air cavity extends along the first direction; and
forming an encapsulating layer on a cavity wall of the air cavity, where the air cavity and the encapsulating layer jointly form the air gap structure.

In some embodiments, materials of the initial isolation structure and the encapsulating layer include an oxide.

In some embodiments, the active pillars in the plurality of repeating units are arranged in a square close-packed manner; the method further includes:
forming landing pads on top surfaces of the active pillars; and
forming memory elements on top surfaces of the landing pads.

In some embodiments, the active pillars in the plurality of repeating units are arranged in a hexagonal close-packed manner; the method further includes:
forming memory elements on top surfaces of the active pillars.

In some embodiments, the forming, on the substrate, a plurality of repeating units spaced apart in parallel and word lines located between the adjacent repeating units includes:
forming a plurality of initial active structures spaced apart in parallel on the substrate, the plurality of initial active structures extending along a third direction, and the third direction intersecting with both the first direction and the second direction;
forming initial isolation structures and initial sacrificial structures conformally stacked in gaps between adjacent initial active structures;
patterning the initial active structures, the initial isolation structures, and the initial sacrificial structures to form intermediate active structures, intermediate isolation structures, intermediate sacrificial structures, and a plurality of isolation grooves, the plurality of isolation grooves extending along the second direction;
forming initial isolation units in the plurality of isolation grooves;
patterning the intermediate active structures, the intermediate isolation structures, the intermediate sacrificial structures, and the initial isolation units to form a plurality of first repeating units and a plurality of second repeating units alternately arranged in the first direction, isolation units located between any of the first repeating units and second repeating units adjacent thereto, as well as a plurality of word line trenches, where each of the plurality of first repeating units includes a first active structure and a first sacrificial structure arranged side by side in the second direction as well as an encapsulating layer surrounding the first sacrificial structure; each of the plurality of second repeating units includes a second sacrificial structure and a second active structure arranged side by side in the second direction as well as an encapsulating layer surrounding the second sacrificial structure; each of the plurality of word line trenches extends along the first direction;
forming the word lines in the plurality of word line trenches; and
removing the first sacrificial structure and the second sacrificial structure to correspondingly form a first air gap structure and a second air gap structure.

In some embodiments, a material of the initial isolation structure includes an oxide;
a material of the initial sacrificial structure includes a nitride; and
a material of the initial isolation unit includes an oxide.

In some embodiments, forming the word lines in the plurality of word line trenches includes:
forming a gate oxide layer on sidewalls of the word line trenches; and
forming the word lines on sidewalls of the gate oxide layer.

The semiconductor structure and the method for manufacturing the same provided according to the present disclosure can have at least the following beneficial effects:
In the embodiments of the present disclosure, by providing a plurality of word lines spaced apart in parallel and extending along the first direction on the substrate, the semiconductor structure is favorably formed into a vertical transistor architecture, thereby reducing the planar size of the semiconductor structure. Compared with the memory cell in the related art which occupies an area of 6F², the semiconductor structure in the embodiments of the present disclosure can occupy an area of 4F², achieving higher storage density. Meanwhile, in the embodiments of the present disclosure, active structures and air gap structures are arranged side by side in the second direction and are arranged sequentially in gaps between adjacent word lines to form the repeating units, such that a structure where the word line, the active structure, the air gap structure, and another word line are arranged sequentially is formed. This arrangement facilitates the achievement of higher storage density while avoiding the problems of large parasitic capacitance, proximity gate effect, and the like caused by tight coupling between adjacent word lines. As a result, the production yield and the electrical properties of the semiconductor structure are improved.

Moreover, in the embodiments of the present disclosure, since the word lines are formed between adjacent repeating units, the problem of difficult word line etching caused by manufacturing process limitations in the related art can be overcome. This facilitates the achievement of higher storage density while simplifying the manufacturing process of the semiconductor structure, thereby improving the production efficiency and the production yield of the semiconductor structure.

### BRIEF DESCRIPTION OF THE DRAWINGS

To more clearly illustrate the technical solutions in the embodiments of the present disclosure or the conventional technology, a brief introduction to the drawings required for the description of the embodiments or the conventional technology is given hereinafter. It is evident that the drawings described hereinafter are merely some embodiments of the present disclosure. For those of ordinary skill in the art, other drawings may also be obtained based on these drawings without creative efforts.
FIG. 1 is a schematic sectional view of a semiconductor structure according to some embodiments of the present disclosure;
FIG. 2(a) is a schematic sectional view of a semiconductor structure when active pillars are arranged in a square close-packed manner according to some embodiments of the present disclosure; FIG. 2(b) is a schematic sectional view of a semiconductor structure when active pillars are arranged in a hexagonal close-packed manner according to some embodiments of the present disclosure;
FIG. 3(a) is a schematic cross-sectional view of a semiconductor structure when active pillars are arranged in a square close-packed manner according to some embodiments of the present disclosure; FIG. 3(b) is a schematic cross-sectional view of a semiconductor structure when active pillars are arranged in a hexagonal close-packed manner according to some embodiments of the present disclosure;
FIG. 4 is a schematic cross-sectional view of a semiconductor structure according to other embodiments of the present disclosure;
FIG. 5 is a schematic sectional view of a semiconductor structure according to other embodiments of the present disclosure;
FIG. 6(a) is a schematic cross-sectional view of a semiconductor structure when active pillars are arranged in a square close-packed manner according to some embodiments of the present disclosure; FIG. 6(b) is a schematic cross-sectional view of a semiconductor structure when active pillars are arranged in a hexagonal close-packed manner according to some embodiments of the present disclosure;
FIG. 7 is a schematic flowchart of a method for manufacturing a semiconductor structure according to some embodiments of the present disclosure;
FIG. 8 is a schematic flowchart of a method for manufacturing a semiconductor structure according to some embodiments of the present disclosure, where a plurality of repeating units spaced apart in parallel and word lines located between adjacent repeating units are formed;
FIG. 9 is a schematic flowchart of a method for manufacturing a semiconductor structure according to other embodiments of the present disclosure, where a plurality of repeating units spaced apart in parallel and word lines located between adjacent repeating units are formed;
FIG. 10 is a schematic sectional view of a structure obtained after forming an initial isolation structure in a method for manufacturing a semiconductor structure according to some embodiments of the present disclosure;
FIG. 11 is a schematic sectional view of a structure obtained after forming a word line in a method for manufacturing a semiconductor structure according to some embodiments of the present disclosure;
FIG. 12 is a schematic sectional view of a structure obtained after forming an encapsulating layer in a method for manufacturing a semiconductor structure according to some embodiments of the present disclosure;
FIG. 13 is a schematic sectional view of a structure obtained after forming an initial isolation structure and an initial sacrificial structure conformally stacked in a method for manufacturing a semiconductor structure according to other embodiments of the present disclosure;
FIG. 14 is a schematic sectional view of a structure obtained after forming an initial isolation unit in a method for manufacturing a semiconductor structure according to other embodiments of the present disclosure;
FIG. 15 is a schematic sectional view of a structure obtained after forming a word line in a method for manufacturing a semiconductor structure according to other embodiments of the present disclosure; and
FIG. 16 is a schematic sectional view of a structure obtained after forming a first air gap structure and a second air gap structure in a method for manufacturing a semiconductor structure according to other embodiments of the present disclosure.

Reference numerals in the figures are as follows:
2. Word line; 3. Repeating unit; 310. Active structure; 311. Active pillar; 311A. Initial active structure; 311B. Intermediate active structure; 312. Isolation pillar; 312A. Initial isolation structure; 312B. Intermediate isolation structure; 320. Air gap structure; 321. Air cavity; 322. Encapsulating layer; 330. First repeating unit; 331. First active structure; 332. First air gap structure; 340. Second repeating unit; 341. Second air gap structure; 342. Second active structure; 350. Isolation unit; 350A. Initial isolation unit; 360A. Initial sacrificial structure; 360B. Intermediate sacrificial structure; 361. First sacrificial structure; 362. Second sacrificial structure; 4. Gate oxide layer; 5. Bit line; 6. Memory element; 6'. Landing pad; L1. First distance; L2. Second distance.

### DETAILED DESCRIPTION

To facilitate understanding of the present disclosure, a more comprehensive description of the present disclosure will be provided hereinafter with reference to the relevant drawings. The drawings illustrate the preferred embodiments of the present disclosure. However, the present disclosure can be implemented in many different forms and is not limited to the embodiments described herein. Rather, these embodiments are provided to make the disclosed contents of the present disclosure more thorough and comprehensive.

Unless otherwise defined, all technical and scientific terms used herein have the same meaning as commonly understood by those skilled in the art to which the present disclosure belongs. The terms used in the specification of the present disclosure are for the purpose of describing particular embodiments only and are not intended to limit the present disclosure.

It should be understood that when an element or a layer is referred to as being "on", "adjacent to", or "connected to" another element or layer, it may be directly on, adjacent to, or connected to the another element or layer, or an intervening element or layer may be present. It should be understood that although terms such as "first", "second", and "third" may be used to describe various elements, components, regions, layers, doping types, and/or portions, the elements, components, regions, layers, doping types, and/or portions should not be limited by these terms. These terms are only used to distinguish one element, component, region, layer, doping type, or portion from another element, component, region, layer, doping type, or portion. Therefore, the first element, component, region, layer, doping type, or portion discussed hereinafter may be referred to as the second element, component, region, layer, doping type, or portion without departing from the teachings of the present disclosure; for example, a first repeating unit may be referred to as a second repeating unit, and similarly, a second repeating unit may be referred to as a first repeating unit; the first repeating unit and the second repeating unit are different repeating units.

Spatial relationship terms such as "on" and "above" may be used herein to describe the relationship of one element or feature to another element or feature as illustrated in the figures. It should be understood that the spatial relationship terms also include different orientations of the device in use or operation in addition to the orientations illustrated in the figures. For example, if the device in the figures is turned over, elements or features described as being "above" other elements or features would be oriented "below" the other elements or features. Therefore, the exemplary terms "on" and "above" may encompass both upward and downward orientations. In addition, the device may include additional orientations (e.g., rotated 90 degrees or at other orientations), and the spatial descriptive terms used herein should be interpreted accordingly.

As used herein, the singular forms "a", "an", and "the" may include the plural forms as well, unless the context clearly indicates otherwise. It should also be understood that the terms "comprise" and/or "include", when used in the specification, may specify the presence of stated features, integers, steps, operations, elements, and/or components, but do not preclude the presence or addition of one or more other features, integers, steps, operations, elements, components, and/or groups.

The embodiments of the present disclosure are described herein with reference to the schematic cross-sectional views of the ideal embodiments (and intermediate structures) of the present disclosure, such that variations in the shapes shown are to be expected, for example, due to manufacturing techniques and/or tolerances. Thus, the embodiments of the present disclosure should not be limited to the specific shapes of regions shown herein but should include shape deviations resulting from manufacturing techniques, for example. The regions shown in the figures are essentially illustrative, and their shapes do not represent the actual shapes of the regions of the device, nor do they limit the scope of the present disclosure.

In view of the shortcomings in the prior art, in one aspect, the present disclosure provides a semiconductor structure according to some embodiments, the details thereof are set forth in the following embodiments.

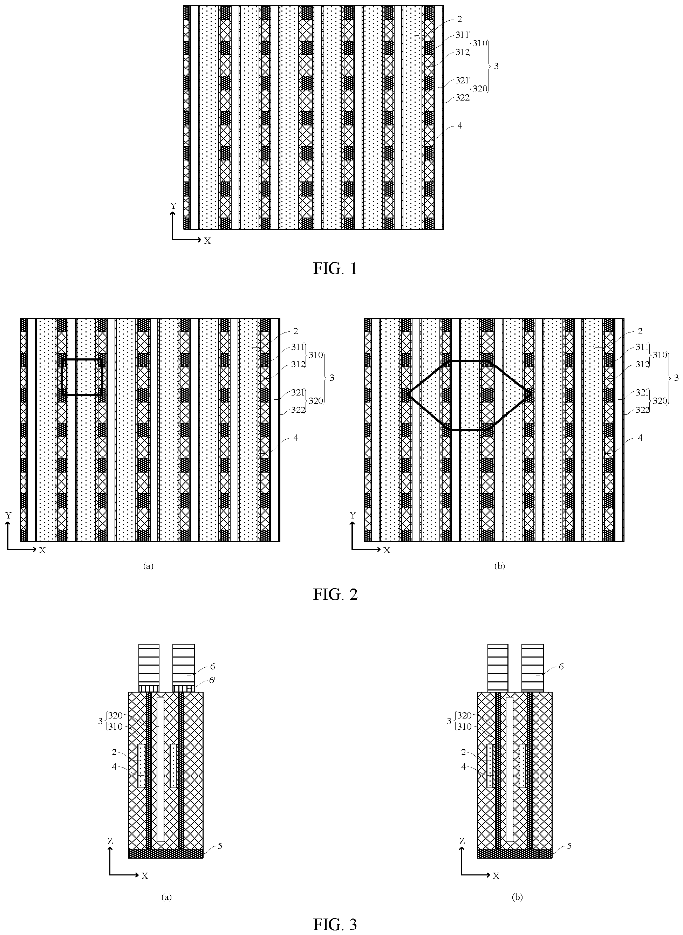

Referring to FIGS. 1 and 2, in some embodiments, the semiconductor structure includes a substrate, a plurality of word lines 2, and a plurality of repeating units 3.

The plurality of word lines 2 are spaced apart in parallel on the substrate and each word line 2 extends along a first direction (e.g., the Y direction); the plurality of repeating units 3 are respectively located in gaps between adjacent word lines 2. Each repeating unit 3 may include an active structure and an air gap structure arranged side by side in a second direction (e.g., in the X direction).

It should be noted that in the embodiments of the present disclosure, the second direction intersects with the first direction. For example, the first direction may be the Y direction and the second direction may be the X direction.

In the semiconductor structure provided according to the above embodiments, by providing a plurality of word lines 2 spaced apart in parallel and extending along the first direction (e.g., the Y direction) on the substrate, the semiconductor structure is formed into a vertical architecture, thereby reducing the planar size of the semiconductor structure. Compared with the memory cell in the related art which occupies an area of 6F², the semiconductor structure in the embodiments of the present disclosure can occupy an area of 4F², achieving higher storage density. Meanwhile, in the above embodiments, active structures and air gap structures are arranged side by side in the second direction (e.g., the X direction) and are arranged sequentially in gaps between adjacent word lines 2 to form the repeating units 3, such that a structure where the word line 2, the active structure, the air gap structure, and another word line 2 are arranged sequentially is formed. This arrangement facilitates the achievement of higher storage density while avoiding the problems of large parasitic capacitance, proximity gate effect, and the like caused by tight coupling between adjacent word lines 2. As a result, the production yield and the electrical properties of the semiconductor structure are improved.

In some embodiments, as shown in FIG. 1, the active structure 310 may include a plurality of active pillars 311 spaced apart in the first direction (e.g., the Y direction) and an isolation pillar 312 located between adjacent active pillars 311.

In some embodiments, as shown in FIG. 1, the air gap structure 320 may include an air cavity 321 extending along the first direction (e.g., the Y direction) and an encapsulating layer 322 surrounding and enclosing the air cavity 321.

Two opposite sidewalls of the encapsulating layer 322 in the second direction (e.g., the X direction) may cover the sidewall of the adjacent active structure 310 and the sidewall of the adjacent word line 2, respectively.

The present disclosure does not specifically limit the orthographic projection shape of the active pillar 311 on the substrate. In some embodiments, the shape of the orthographic projection of the active pillar 311 on the substrate is an irregular quadrilateral.

In other embodiments, as shown in FIG. 1, the air cavity 321 is a strip-shaped air cavity. In the embodiment, the shape of the orthographic projection of the active pillar 311 on the substrate is a rectangle. It can be understood that when the orthographic projection shape of the active pillar 311 on the substrate is a rectangle, the orthographic projection shape of the isolation pillar 312 on the substrate is also a rectangle.

The present disclosure does not specifically limit the size of the active structure 310 and the air gap structure 320. In some embodiments, the active structure 310 and the air gap structure 320 are equal in size in the second direction (e.g., the X direction).

The present disclosure does not specifically limit the distance between adjacent active pillars 311. In some embodiments, the distance between adjacent active pillars 311 in the first direction (e.g., the Y direction) is equal to the distance between adjacent active pillars 311 in the second direction (e.g., the X direction).

Referring to FIG. 2(a), in some embodiments, the active pillars 311 in the plurality of repeating units 3 may be arranged in a square close-packed manner.

Referring to FIG. 3(a) for understanding, in some embodiments, the semiconductor structure may further include a plurality of landing pads 6' and a plurality of memory elements 6. The plurality of landing pads 6' may be respectively disposed on the top surfaces of the corresponding active pillars 311, and the plurality of memory elements 6 may be respectively disposed on the top surfaces of the corresponding landing pads 6'.

The present disclosure does not specifically limit the form of the memory element 6. As an example, the memory element 6 may include but is not limited to a storage capacitor.

In other embodiments, as shown in FIG. 2(b), the active pillars 311 in the plurality of repeating units 3 may be arranged in a hexagonal close-packed manner.

Referring to FIG. 3(b) for understanding, in some embodiments, the semiconductor structure further includes a plurality of memory elements 6 respectively disposed on the top surfaces of the corresponding active pillars 311.

In the semiconductor structure provided according to the above embodiments, the active pillars 311 are arranged in a hexagonal close-packed manner to form a cellular structure, eliminating the need to provide landing pads 6' on the tops of the active pillars 311 or to lead out and then rearrange the active pillars 311. Therefore, the manufacturing process of the semiconductor structure is simplified and the production efficiency and the production yield are improved.

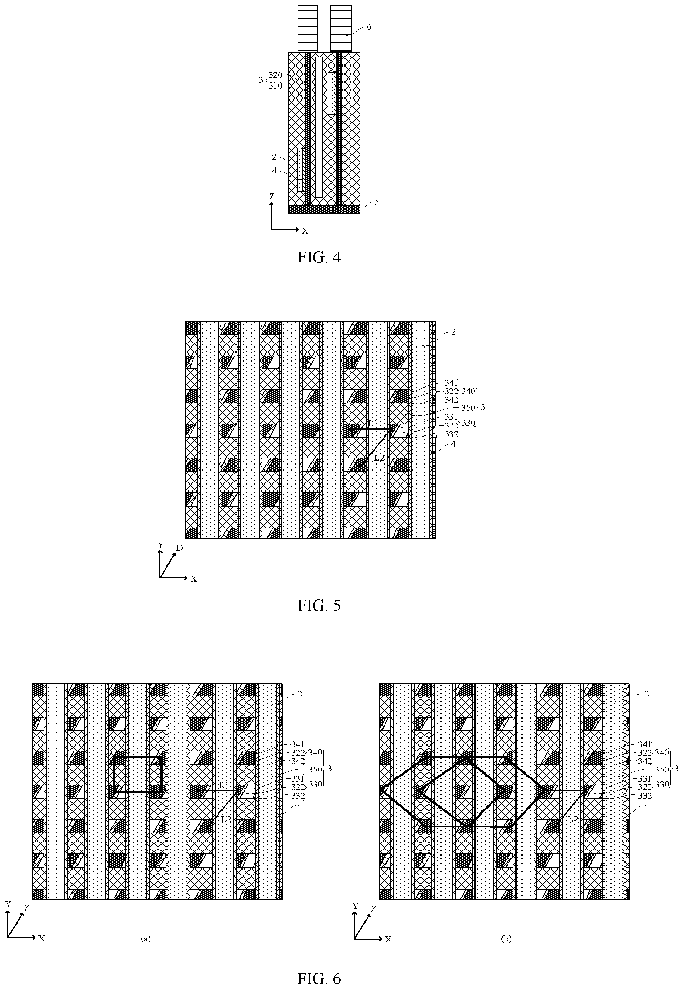

It should be noted that referring to FIG. 4, in the embodiments of the present disclosure, two adjacent word lines 2 in the second direction (e.g., the X direction) may be offset in a direction perpendicular to the substrate, such that the isolation effect between adjacent word lines 2 can be further improved and the interference between adjacent word lines 2 can be reduced. This reduces the static leakage of the semiconductor structure during use and improves the production yield and the electrical properties of the semiconductor structure.

Two adjacent word lines 2 in the second direction (e.g., the X direction) may include a word line 2 closer to the substrate and a word line 2 farther from the substrate. As an example, the bottom surface of the word line 2 farther from the substrate may be flush with the top surface of the word line 2 closer to the substrate. In other examples, as shown in FIG. 4, the bottom surface of the word line 2 farther from the substrate may be higher than the top surface of the word line 2 closer to the substrate, such that the isolation effect between adjacent word lines 2 can be better improved and the interference between adjacent word lines 2 can be reduced. This further reduces the static leakage of the semiconductor structure during use and improves the production yield and the electrical properties of the semiconductor structure.

In other embodiments, as shown in FIG. 5, the repeating unit 3 may include a plurality of first repeating units 330 and a plurality of second repeating units 340 alternately arranged in the first direction (e.g., the Y direction) as well as isolation units 350 located between any first repeating unit 330 and an second repeating unit 340 adjacent thereto.

The first repeating unit 330 may include a first active structure 331 and a first air gap structure 332 arranged side by side in the second direction (e.g., the X direction). The second repeating unit 340 may include a second air gap structure 341 and a second active structure 342 arranged side by side in the second direction (e.g., the X direction). In the embodiment, the first active structure 331 and the second air gap structure 341 are alternately arranged in the first direction (e.g., the Y direction) and the second active structure 342 and the first air gap structure 332 are alternately arranged in the first direction (e.g., the Y direction).

It should be noted that in some embodiments, the repeating unit 3 may further include an encapsulating layer 322. The encapsulating layer 322 may surround the first air gap structure 332 and the second air gap structure 341.

The present disclosure does not specifically limit the orthographic projection shapes of the first repeating unit 330 and the second repeating unit 340 on the substrate. In some embodiments, as shown in FIG. 5, the orthographic projection shapes of the first repeating unit 330 and the second repeating unit 340 on the substrate are both rectangles.

In some embodiments, as shown in FIG. 5, the orthographic projection of the first active structure 331 on the substrate and the orthographic projection of a second active structure 342 adjacent to the first active structure 331 in the first direction (e.g., the Y direction) on the substrate are two sub-regions of the same rectangle, respectively. That is, the orthographic projection shape of the first active structure 331 on the substrate and the orthographic projection shape of the second active structure 342 on the substrate may be spliced to form a complete rectangle.

In some embodiments, as shown in FIG. 5, the orthographic projection of the first active structure 331 on the substrate and the orthographic projection of a second active structure 342 adjacent to the first active structure 331 in the first direction (e.g., the Y direction) on the substrate are two sub-regions of the same rectangle, respectively. That is, the area of the orthographic projection shape of the first active structure 331 on the substrate and the area of the orthographic projection shape of the second active structure 342 on the substrate are not consistent.

In some embodiments, as shown in FIG. 5, the plurality of first active structures 331 are arranged in rows in the second direction (e.g., the X direction), and the plurality of second active structures 342 are arranged in rows in the second direction (e.g., the X direction). The first active structures 331 in adjacent rows and the second active structures 342 in adjacent rows are arranged in columns in the third direction (e.g., the D direction).

It should be noted that in the embodiments of the present disclosure, the third direction intersects with both the first direction and the second direction. For example, the third direction may be the D direction, the first direction may be the Y direction, and the second direction may be the X direction.

The present disclosure does not specifically limit the distance between adjacent first active structures 331 and the distance between the first active structure 331 and an adjacent second active structure 342. It should be noted that the distance between adjacent first active structures 331 refers to the distance between the geometric center of the first active structure 331 and the geometric center of an adjacent first active structure 331; the distance between the first active structure 331 and an adjacent second active structure 342 refers to the distance between the geometric center of the first active structure 331 and the geometric center of the adjacent second active structure 342.

For convenience of description, as shown in FIG. 5, the distance between the first active structure 331 and a first active structure 331 adjacent to the first active structure 331 in the second direction (e.g., the X direction) is defined as a first distance L1, and the distance between the first active structure 331 and a second active structure 342 adjacent to the first active structure 331 in the third direction (e.g., the D direction) is defined as a second distance L2.

In some embodiments, the second distance L2 is equal to the first distance L1.

The present disclosure does not specifically limit the orthographic projection shapes of the first active structure 331, the first air gap structure 332, the first active structure 331, and the first air gap structure 332 on the substrate. In some embodiments, the orthographic projections of the first active structure 331 and the second air gap structure 341 on the substrate have the same shape. In some embodiments, the orthographic projections of the second active structure 342 and the first air gap structure 332 on the substrate have the same shape.

For convenience of description, shapes of the orthographic projections of the first active structure 331 and the second air gap structure 341 on the substrate are defined as a first shape, and shapes of the orthographic projections of the second active structure 342 and the first air gap structure 332 on the substrate are defined as a second shape. In some embodiments, both the first shape and the second shape are triangles or trapezoids. In other embodiments, one of the first shape and the second shape is a triangle and the other is a trapezoid; that is, the first shape is a triangle and the second shape is a trapezoid or the second shape is a triangle and the first shape is a trapezoid.

In the above embodiments, the first active structure 331 and the second active structure 342 may jointly constitute the active structure, and the first air gap structure 332 and the second air gap structure 341 may jointly form the air gap structure. It can be understood that both the first active structure 331 and the second active structure 342 are also active pillars.

It can be understood that in some embodiments, as shown in FIG. 6(a), the active pillars (the first active structure 331 and the second active structure 342) in the plurality of repeating units 3 may also be arranged in a square close-packed manner.

As an example, the semiconductor structure may further include a plurality of landing pads 6' and a plurality of memory elements 6. The plurality of landing pads 6' may be respectively disposed on the top surfaces of the corresponding active pillars and the plurality of memory elements 6 may be respectively disposed on the top surfaces of the corresponding landing pads 6'.

In other embodiments, as shown in FIG. 6(b), the active pillars (the first active structure 331 and the second active structure 342) in the plurality of repeating units 3 may also be arranged in a hexagonal close-packed manner.

As an example, the semiconductor structure further includes a plurality of memory elements 6 respectively disposed on the top surfaces of the corresponding active pillars 311.

In some embodiments, the semiconductor structure may further include gate oxide layers 4. The gate oxide layers 4 are located between the repeating units 3 and the word line 2 adjacent to the repeating units 3.

With continued reference to FIG. 3, in some embodiments, the semiconductor structure may further include a plurality of bit lines 5. The plurality of bit lines 5 are spaced apart in parallel on the substrate and located between the substrate and the repeating units 3.

The positions of the bit lines 5 will be described by taking an example where the repeating unit 3 includes an active structure 310 and an air gap structure 320 arranged side by side in the second direction (e.g., the X direction). The bit lines 5 may extend along the second direction (e.g., the X direction) and be correspondingly connected to the plurality of active structures 310 arranged along the second direction (e.g., the X direction).

In another aspect, the present disclosure further provides a method for manufacturing a semiconductor structure according to some embodiments.

It should be noted that the methods for manufacturing a semiconductor structure in the embodiments of the present disclosure can all be used to manufacture the corresponding semiconductor structures. Therefore, the technical features between the embodiments of the methods and the embodiments of the structures can be interchanged and supplemented without conflict, allowing those skilled in the art to learn the technical content of the present disclosure.

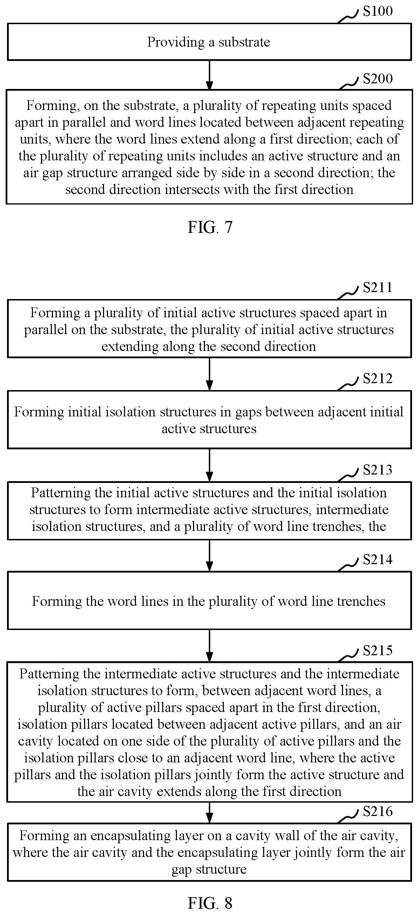

Referring to FIG. 7, in some embodiments, the method for manufacturing a semiconductor structure may include the following steps:
In S100, a substrate is provided.
In S200, a plurality of repeating units spaced apart in parallel and word lines located between adjacent repeating units are formed on the substrate.

The word lines are spaced apart in parallel on the substrate and extend along the first direction; the repeating unit may include an active structure and an air gap structure arranged side by side in the second direction.

In the method for manufacturing a semiconductor structure provided according to the above embodiments, by forming a plurality of word lines spaced apart in parallel and extending along the first direction (e.g., the Y direction) on the substrate, the manufactured semiconductor structure is formed into a vertical architecture, thereby reducing the planar size of the semiconductor structure. Compared with the memory cell in the related art which occupies an area of 6F², the manufactured semiconductor structure in the embodiments of the present disclosure can occupy an area of 4F², achieving higher storage density. Meanwhile, in the above embodiments, active structures and air gap structures are arranged side by side in the second direction (e.g., the X direction) and are arranged sequentially in gaps between adjacent word lines to form the repeating units, such that a structure where the word line, the active structure, the air gap structure, and another word line are arranged sequentially is formed. This arrangement facilitates the achievement of higher storage density while avoiding the problems of large parasitic capacitance, proximity gate effect, and the like caused by tight coupling between adjacent word lines. As a result, the production yield and the electrical properties of the manufactured semiconductor structure are improved.

Referring to FIG. 8, in some embodiments, step S200 of forming the plurality of repeating units spaced apart in parallel and the word lines located between the adjacent repeating units on the substrate may include the following steps:
In S211, a plurality of initial active structures spaced apart in parallel are formed on the substrate, the initial active structures extending along the second direction.
In S212, initial isolation structures are formed in gaps between adjacent initial active structures.
In S213, the initial active structures and the initial isolation structures are patterned to form intermediate active structures, intermediate isolation structures, and a plurality of word line trenches, the word line trenches extending along the first direction.
In S214, word lines are formed in the word line trenches.
In S215, the intermediate active structures and the intermediate isolation structures are patterned to form, between adjacent word lines, a plurality of active pillars spaced apart in the first direction, isolation pillars located between adjacent active pillars, and an air cavity located on one side of the active pillars and the isolation pillars close to an adjacent word line, where the active pillars and the isolation pillars jointly form the active structure and the air cavity extends along the first direction.
In S216, an encapsulating layer is formed on the cavity wall of the air cavity, where the air cavity and the encapsulating layer jointly form the air gap structure.

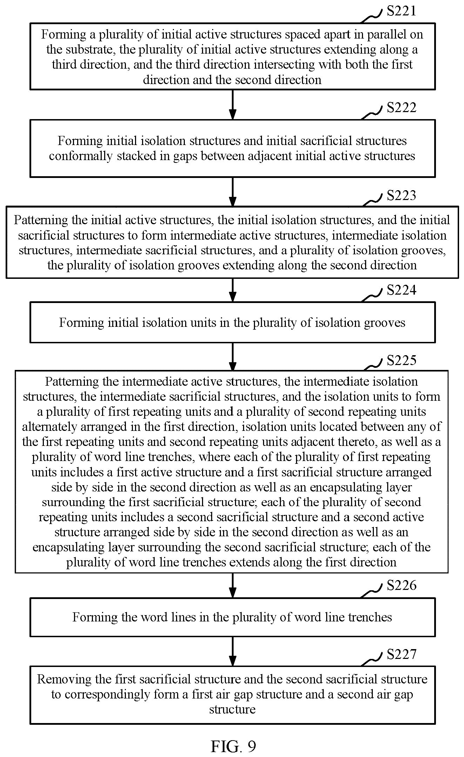

Referring to FIG. 9, in other embodiments, step S200 of forming the plurality of repeating units spaced apart in parallel on the substrate and the word lines located between the adjacent repeating units may include the following steps:

In S221, a plurality of initial active structures spaced apart in parallel are formed on the substrate, the initial active structures extending along a third direction and the third direction intersecting with both the first direction and the second direction.

In S222, initial isolation structures and initial sacrificial structures are formed conformally stacked in gaps between adjacent initial active structures.

In S223, the initial active structures, the initial isolation structures, and the initial sacrificial structures are patterned to form intermediate active structures, intermediate isolation structures, intermediate sacrificial structures, and a plurality of isolation grooves, the isolation grooves extending along the second direction.

In S224, initial isolation units are formed in the isolation grooves.

In S225, the intermediate active structures, the intermediate isolation structures, the intermediate sacrificial structures, and the initial isolation units are patterned to form a plurality of first repeating units and a plurality of second repeating units alternately arranged in the first direction, isolation units located between any of the first repeating units and second repeating units adjacent thereto, and a plurality of word line trenches, where each first repeating unit includes a first active structure and a first sacrificial structure arranged side by side in the second direction and an encapsulating layer surrounding the first sacrificial structure; each second repeating unit includes a second sacrificial structure and a second active structure arranged side by side in the second direction and an encapsulating layer surrounding the second sacrificial structure; each word line trench extends along the first direction.

In S226, word lines are formed in the word line trenches.

In S227, the first sacrificial structure and the second sacrificial structure are removed to correspondingly form a first air gap structure and a second air gap structure.

It should be understood that although the steps in the flowcharts of FIGS. 7 to 9 are shown in sequence according to the arrows, these steps are not necessarily executed in the order indicated by the arrows. Unless explicitly stated herein otherwise, there is no strict order limitation on the execution of these steps, and they may be executed in other sequences. Moreover, at least a portion of the steps in FIGS. 7 to 9 may include a plurality of steps or a plurality of stages, and these steps or stages are not necessarily executed or completed at the same time but may be executed at different times. These steps or stages are not necessarily executed in a sequential order but may be executed alternately or in rotation with at least a portion of other steps, or steps or stages from other steps.

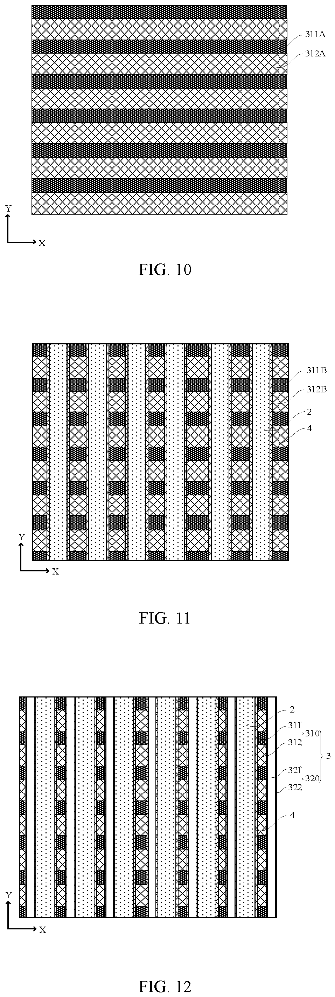

To more clearly illustrate the manufacturing methods in the above embodiments, refer to FIGS. 10 to 16 to understand some embodiments of the present disclosure.

In step S100, a substrate is provided.

The present disclosure does not specifically limit the materials of the substrate, and the substrate may be made of a semiconductor material, an insulating material, a conductor material, or any combination of these types of materials. The substrate may be a single-layer structure or a multi-layer structure. For example, the substrate may be a silicon (Si) substrate, a silicon-germanium (SiGe) substrate, a silicon-germanium-carbon (SiGeC) substrate, a silicon carbide (SiC) substrate, a gallium arsenide (GaAs) substrate, an indium arsenide (InAs) substrate, an indium phosphide (InP) substrate, or other III/V semiconductor substrates or II/VI semiconductor substrates. Alternatively, for example, the substrate may be a stack including layers such as Si and SiGe, Si and SiC, silicon-on-insulator (SOI), a layered substrate of silicon-germanium-on-insulator, or the like.

In step S200, a plurality of repeating units 3 spaced apart in parallel and word lines 2 located between adjacent repeating units 3 are formed on the substrate. The word lines 2 extend along the first direction (e.g., the Y direction); the repeating unit 3 is located in a gap between adjacent word lines 2 and may specifically include an active structure 310 and an air gap structure 320 arranged side by side in the second direction (e.g., the X direction).

In the embodiments of the present disclosure, since the word lines 2 are formed between adjacent repeating units 3, the problem of difficult word line etching caused by manufacturing process limitations in the related art can be overcome. This facilitates the achievement of higher storage density while simplifying the manufacturing process of the semiconductor structure, thereby improving the manufacturing efficiency and manufacturing yield of the semiconductor structure.

The present disclosure does not specifically limit the materials of the word line 2. As an example, the materials of the word line 2 may include but are not limited to one or more of conductive polycrystalline silicon (abbreviated as Poly), metals, conductive metal nitrides, conductive metal oxides, and metal silicides. Such metals include tungsten (W), nickel (Ni), copper (Cu), aluminum (Al), molybdenum (Mo), ruthenium (Ru), tantalum (Ta), titanium (Ti), or the like; the conductive metal nitrides include titanium nitride (TiN) or the like; the conductive metal oxides include iridium oxide (IrO2) or the like; the metal silicides include tungsten silicon (WSi) or the like.

In some embodiments, referring to FIGS. 10 to 12, step S200 of forming the plurality of repeating units 3 spaced apart in parallel and the word lines 2 located between the adjacent repeating units 3 on the substrate may be embodied as the following steps S211 to S216:

In step S211, as shown in FIG. 10, a plurality of initial active structures 311A spaced apart in parallel are formed on the substrate, the initial active structures 311A extending along the second direction (e.g., the X direction).

In step S212, as shown in FIG. 10, initial isolation structures 312A are formed in the gaps between adjacent initial active structures 311A.

In step S213, as shown in FIG. 11, the initial active structures 311A and the initial isolation structures 312A are patterned to form intermediate active structures 311B, intermediate isolation structures 312B, and a plurality of word line trenches, the plurality of word line trenches extending along the first direction (e.g., the Y direction).

In step S214, as shown in FIG. 11, word lines 2 are formed in the word line trenches.

In step S215, as shown in FIG. 12, the intermediate active structures 311B and the intermediate isolation structures 312B are patterned to form, between adjacent word lines 2, a plurality of active pillars 311 spaced apart in the first direction (e.g., the Y direction), isolation pillars 312 located between adjacent active pillars 311, and an air cavity 321 located on one side of the active pillars 311 and the isolation pillars 312 close to an adjacent word line 2.

It can be understood that the active pillar 311 and the isolation pillar 312 may jointly form the active structure 310 and the air cavity 321 extends along the first direction (e.g., the Y direction).

In step S216, as shown in FIG. 12, an encapsulating layer 322 is formed on the cavity wall of the air cavity 321.

It can be understood that the air cavity 321 and the encapsulating layer 322 may jointly form the air gap structure 320. The active structure 310 and the air gap structure 320 may jointly form a repeating unit 3.

The present disclosure does not specifically limit the materials of the initial isolation structure 312A formed in step S212. In some embodiments, the materials of the initial isolation structure 312A may include but are not limited to oxide materials. It can be understood that the material of the intermediate isolation structure 312B is the material of the initial isolation structure 312A, and the material of the isolation pillar 312 is the material of the intermediate isolation structure 312B. Therefore, the material of the initial isolation structure 312A may be selected according to the actual requirements for the material of the isolation pillar 312. As an example, the oxide materials may include silicon oxide (SiO2) or other insulating materials.

The present disclosure does not specifically limit the materials of the encapsulating layer 322 formed in step S216. In some embodiments, the materials of the encapsulating layer 322 may include but are not limited to oxide materials. As an example, the oxide materials may include silicon oxide or other insulating materials.

The initial isolation structure 312A and the encapsulating layer 322 described above may be made of the same or different materials, both are permissible. As an example, the initial isolation structure 312A and the encapsulating layer 322 may be made of the same material; for example, the material of the initial isolation structure 312A and the material of the encapsulating layer 322 both include silicon oxide.

In some embodiments, in the structure obtained in step S200, the active pillars 311 in the plurality of repeating units 3 may be arranged in a square close-packed manner.

Referring to FIG. 3(a) for understanding, in some embodiments, the method for manufacturing a semiconductor structure may further include the following steps:
Landing pads 6' are formed on the top surfaces of the active pillars 311; and after forming the landing pads 6', memory elements 6 are formed on the top surfaces of the landing pads 6'.

In other embodiments, in the structure obtained in step S200, the active pillars 311 in the plurality of repeating units 3 are arranged in a hexagonal close-packed manner.

Referring to FIG. 3(b) for understanding, in some embodiments, the method for manufacturing a semiconductor structure may further include the following steps:

Memory elements 6 are formed on the top surfaces of the active pillars 311.

In the method for manufacturing a semiconductor structure provided according to the above embodiments, the active pillars are arranged in a hexagonal close-packed manner to form a cellular structure, eliminating the need to provide landing blocks on the tops of the active pillars or to lead out and rearrange the active pillars. Therefore, the manufacturing process of the semiconductor structure is simplified and the production efficiency and the production yield are improved.

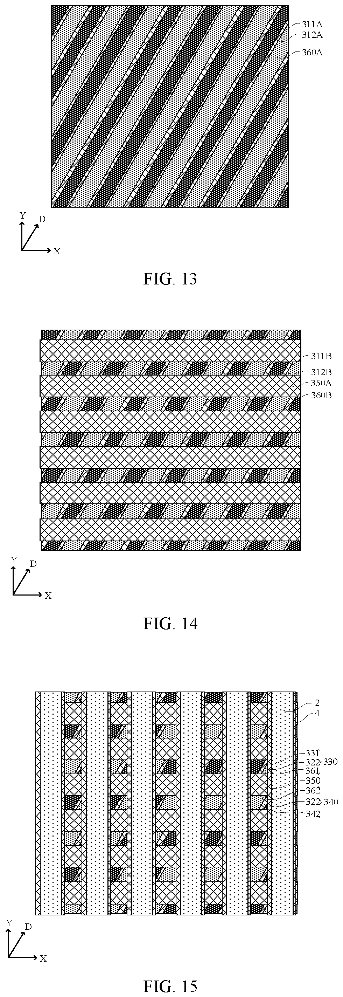

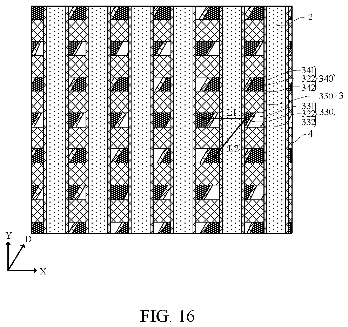

In other embodiments, referring to FIGS. 13 to 16, step S200 of forming the plurality of repeating units 3 spaced apart in parallel and the word lines 2 located between the adjacent repeating units 3 on the substrate may be embodied as the following steps S221 to S227:
In step S221, as shown in FIG. 13, a plurality of initial active structures 311A spaced apart in parallel are formed on the substrate, the plurality of initial active structures 311A extending along the third direction (e.g., the D direction).
In step S222, as shown in FIG. 13, initial isolation structures 312Aand initial sacrificial structures 360A are formed conformally stacked in the gaps between adjacent initial active structures 311A.
In step S223, as shown in FIG. 14, the initial active structures 311A, the initial isolation structures 312A, and the initial sacrificial structures 360A are patterned to form intermediate active structures 311B, intermediate isolation structures 312B, intermediate sacrificial structures 360B, and a plurality of isolation grooves, the isolation grooves extending along the second direction (e.g., the X direction).
In step S224, as shown in FIG. 14, initial isolation units 350A are formed in the isolation grooves.
In step S225, as shown in FIG. 15, the intermediate active structures 311B, the intermediate isolation structures 312B, the intermediate sacrificial structures 360B, and the initial isolation units 350A are patterned to form a plurality of first repeating units 330 and a plurality of second repeating units 340 alternately arranged in the first direction (e.g., the Y direction), isolation units 350 located between any of the first repeating units 330 and second repeating units 340 adjacent thereto, and a plurality of word line trenches. Each first repeating unit 330 may include a first active structure 331 and a first sacrificial structure 361 arranged side by side in the second direction (e.g., the X direction) as well as an encapsulating layer 322 surrounding the first sacrificial structure 361. Each second repeating unit 340 may include a second sacrificial structure 362 and a second active structure 342 arranged side by side in the second direction (e.g., the X direction) as well as an encapsulating layer 322 surrounding the second sacrificial structure 362. Each word line trench may extend along the first direction (e.g., the Y direction).
In step S226, as shown in FIG. 15, word lines 2 are formed in the word line trenches.
In step S227, as shown in FIG. 16, the first sacrificial structure 361 and the second sacrificial structure 362 are removed to correspondingly form a first air gap structure 332 and a second air gap structure 341. That is, in this case, the first repeating unit 330 may include a first active structure 331 and a first air gap structure 332 arranged side by side in the second direction (e.g., the X direction); meanwhile, the second repeating unit 340 may include a second air gap structure 341 and a second active structure 342 arranged side by side in the second direction (e.g., the X direction).

The present disclosure does not specifically limit the materials of the initial sacrificial structure 360A formed in step S222. In some embodiments, the materials of the initial sacrificial structure 360A may include but are not limited to nitride materials. As an example, the nitride materials may include silicon nitride (SiN).

The present disclosure does not specifically limit the materials of the initial isolation unit 350A formed in step S224. In some embodiments, the materials of the initial isolation unit 350A may include but are not limited to oxide materials. It can be understood that the material of the isolation unit 350 is the material of the initial isolation unit 350A. Therefore, the material of the initial isolation unit 350A may be selected according to the actual requirements for the material of the isolation unit 350. As an example, the oxide materials may include silicon oxide or other insulating materials.

The present disclosure does not specifically limit the method for removing the first sacrificial structure 361 and the second sacrificial structure 362 in step S227.

In some embodiments, the first sacrificial structure 361 and the second sacrificial structure 362 may be removed by using a wet cleaning method. By using a wet cleaning method and selecting appropriate etching material, the wet cleaning process may achieve a certain etching selectivity between the first sacrificial structure 361, as well as the second sacrificial structure 362, and other layer structures, such that adverse effects on other layer structures and damages to the obtained structure can be prevented during the removal process of the first sacrificial structure 361 and the second sacrificial structure 362, thereby improving the manufacturing efficiency and the manufacturing yield of the semiconductor structure.

In other embodiments, the first sacrificial structure 361 and the second sacrificial structure 362 may also be removed by using a dry cleaning method. As an example, the first sacrificial structure 361 and the second sacrificial structure 362 may be removed by using ion bombardment.

It can be understood that in the structure obtained in step S200 according to the above embodiments, the first active structure 331 and the second active structure 342 may jointly form the active structure, and the first air gap structure 332 and the second air gap structure 341 may jointly constitute the air gap structure. It can be understood that both the first active structure 331 and the second active structure 342 are also active pillars.

In some embodiments, the active pillars (the first active structure 331 and the second active structure 342) in the plurality of repeating units 3 may also be arranged in a square close-packed manner.

As an example, the method for manufacturing a semiconductor structure may further include the following steps:
Landing pads 6' are formed on the top surfaces of the active pillars (the first active structure 331 and the second active structure 342); and after forming the landing pads 6', memory elements 6 are formed on the top surfaces of the landing pads 6'.

In other embodiments, the active pillars (the first active structure 331 and the second active structure 342) in the plurality of repeating units 3 may be arranged in a hexagonal close-packed manner.

As an example, the method for manufacturing a semiconductor structure may further include the following steps:
Memory elements 6 are formed on the top surfaces of the active pillars (the first active structure 331 and the second active structure 342).

In some embodiments, as shown in FIGS. 9 and 15, the step of forming the word lines 2 in the word line trenches (e.g., steps S214 and S226) may be embodied as the following steps:
A gate oxide layer 4 is formed on the sidewalls of the word line trench; and after forming the gate oxide layer 4, the word line 2 is formed on the sidewalls of the gate oxide layer 4.

The present disclosure does not specifically limit the materials of the gate oxide layer 4. As an example, the gate oxide layer 4 may include silicon oxide, silicon nitride, silicon oxynitride (SiON), or other high-K dielectric materials (with a dielectric constant greater than 3.9), as well as a combination of the aforementioned materials.

The technical features of the above embodiments can be combined in any manner. For the sake of brevity, not all possible combinations of the technical features of the above embodiments are described. However, as long as there is no contradiction in the combination of these technical features, they should all be considered within the scope of the present disclosure. The above embodiments merely express several implementations of the present disclosure. The descriptions are relatively specific and detailed, but they should not be construed as limiting the scope of the patent application. It should be noted that for those of ordinary skill in the art, several modifications and improvements can be made without departing from the spirit of the present disclosure, and these should all fall within the protection scope of the present disclosure. Therefore, the protection scope for the present patent application should be defined by the appended claims.

## Claims

1. A semiconductor structure, comprising:
a substrate;
a plurality of word lines (2) spaced apart in parallel on the substrate, the plurality of word lines (2) extending along a first direction (Y); and
a plurality of repeating units (3) respectively located in gaps between adjacent word lines (2), each of the plurality of repeating units (3) comprising an active structure (310) and an air gap structure (320) arranged side by side in a second direction (X), and the second direction (X) intersecting with the first direction (Y).

2. The semiconductor structure according to claim 1, wherein
the active structure (310) comprises a plurality of active pillars (311) spaced apart in the first direction (Y) and isolation pillars (312) located between adjacent active pillars (311); and
the air gap structure (320) comprises an air cavity (321) extending along the first direction (Y) and an encapsulating layer (322) surrounding and enclosing the air cavity (321), two opposite sidewalls of the encapsulating layer (322) in the second direction (X) covering a sidewall of an adjacent active structure (310) and a sidewall of an adjacent word line (2), respectively.

3. The semiconductor structure according to claim 2, wherein a shape of an orthographic projection of each of the active pillars (311) on the substrate is an irregular quadrilateral.

4. The semiconductor structure according to claim 2, wherein the air cavity (321) is a strip-shaped air cavity; orthographic projection shapes of each of the active pillars (311) and each of the isolation pillars (312) on the substrate are both rectangles.

5. The semiconductor structure according to claim 2 or 4, wherein the active structure (310) and the air gap structure (320) are equal in size in the second direction (X).

6. The semiconductor structure according to any one of claims 2, 4, and 5, wherein a distance between adjacent active pillars (311) in the first direction (Y) is equal to a distance between adjacent active pillars (311) in the second direction (X).

7. The semiconductor structure according to any one of claims 2 to 6, wherein the active pillars (311) in the plurality of repeating units (3) are arranged in a square close-packed manner; and
the semiconductor structure further comprises:
a plurality of landing pads (6') respectively disposed on top surfaces of corresponding active pillars (311); and
a plurality of memory elements (6) respectively disposed on top surfaces of corresponding landing pads (6').

8. The semiconductor structure according to any one of claims 2 to 6, wherein the active pillars (311) in the plurality of repeating units (3) are arranged in a hexagonal close-packed manner; and
the semiconductor structure further comprises:
a plurality of memory elements (6) respectively disposed on top surfaces of corresponding active pillars (311).

9. The semiconductor structure according to claim 1, wherein the repeating unit (3) comprises a plurality of first repeating units (330) and a plurality of second repeating units (340) alternately arranged in the first direction as well as isolation units (350) located between any of the first repeating units (330) and second repeating units (340) adjacent thereto, wherein
each of the plurality of first repeating units (330) comprises a first active structure (331) and a first air gap structure (332) arranged side by side in the second direction (X);
each of the plurality of second repeating units (340) comprises a second air gap structure (341) and a second active structure (342) arranged side by side in the second direction (X);
the first active structure (331) and the second air gap structure (341) are alternately arranged in the first direction (Y); and
the second active structure (342) and the first air gap structure (332) are alternately arranged in the first direction (Y).

10. The semiconductor structure according to claim 9, wherein an orthographic projection of the first active structure (331) on the substrate and an orthographic projection of a second active structure (342) adjacent to the first active structure (331) in the first direction (Y) on the substrate are two sub-regions of a same rectangle, respectively.

11. The semiconductor structure according to claim 9 or 10, wherein a plurality of the first active structures (331) are arranged in rows in the second direction (X) and a plurality of the second active structures (342) are arranged in rows in the second direction (X); and
the first active structures (331) in adjacent rows and the second active structures (342) in adjacent rows are arranged in columns in a third direction (D), the third direction (D) intersecting with both the first direction (Y) and the second direction (X).

12. The semiconductor structure according to claim 11, wherein
a distance between the first active structure (331) and a first active structure (331) adjacent to the first active structure (331) in the second direction (X) is a first distance (L1); and
a distance between the first active structure (331) and a second active structure (342) adjacent to the first active structure (331) in the third direction (D) is a second distance (L2),
wherein the second distance (L2) is equal to the first distance (L1).

13. The semiconductor structure according to any one of claims 9 to 12, wherein
orthographic projections of the first active structure (331) and the second air gap structure (341) on the substrate have a same shape; and
orthographic projections of the second active structure (342) and the first air gap structure (332) on the substrate have a same shape.

14. The semiconductor structure according to claim 13, wherein shapes of the orthographic projections of the first active structure (331) and the second air gap structure (341) on the substrate are a first shape; shapes of the orthographic projections of the second active structure (342) and the first air gap structure (332) on the substrate are a second shape, wherein
both the first shape and the second shape are triangles or trapezoids;
or, one of the first shape and the second shape is a triangle and the other is a trapezoid.

15. The semiconductor structure according to any one of claims 1 to 14, further comprising:
gate oxide layers (4) located between the repeating units (3) and word lines (2) adjacent to the repeating units (3).

16. The semiconductor structure according to any one of claims 1 to 15, further comprising:
a plurality of bit lines (5) spaced apart in parallel on the substrate and located between the substrate and the repeating units (3), the plurality of bit lines (5) extending along the second direction (X) and being correspondingly connected to the plurality of active structures (310) arranged along the second direction (X).

17. A method for manufacturing a semiconductor structure, comprising:
providing a substrate; and
forming, on the substrate, a plurality of repeating units (3) spaced apart in parallel and word lines (2) located between adjacent repeating units (3), wherein the word lines (2) extend along a first direction (Y); each of the plurality of repeating units (3) comprises an active structure (310) and an air gap structure (320) arranged side by side in a second direction (X); the second direction (X) intersects with the first direction (Y).

18. The method for manufacturing a semiconductor structure according to claim 17, wherein the forming, on the substrate, a plurality of repeating units (3) spaced apart in parallel and word lines (2) located between the adjacent repeating units (3) comprises:
forming a plurality of initial active structures (311A) spaced apart in parallel on the substrate, the plurality of initial active structures (311A) extending along the second direction (X);
forming initial isolation structures (312A) in gaps between adjacent initial active structures (311A);
patterning the initial active structures (311A) and the initial isolation structures (312A) to form intermediate active structures (311B), intermediate isolation structures (312B), and a plurality of word line trenches, the plurality of word line trenches extending along the first direction (Y);
forming the word lines (2) in the plurality of word line trenches;
patterning the intermediate active structures (311B) and the intermediate isolation structures (312B) to form, between adjacent word lines (2), a plurality of active pillars (311) spaced apart in the first direction (Y), isolation pillars (312) located between adjacent active pillars (311), and an air cavity (321) located on one side of the plurality of active pillars (311) and the isolation pillars (312) close to an adjacent word line (2), wherein the active pillars (311) and the isolation pillars (312) jointly form the active structure (310) and the air cavity (321) extends along the first direction (Y); and
forming an encapsulating layer (322) on a cavity wall of the air cavity (321), wherein the air cavity (321) and the encapsulating layer (322) jointly form the air gap structure (320).

19. The method for manufacturing a semiconductor structure according to claim 18, wherein the active pillars in the plurality of repeating units are arranged in a square close-packed manner; the method further comprises:
forming landing pads on top surfaces of the active pillars; and
forming memory elements on top surfaces of the landing pads;
or wherein the active pillars in the plurality of repeating units are arranged in a hexagonal close-packed manner; the method further comprises:
forming memory elements on top surfaces of the active pillars.

20. The method for manufacturing a semiconductor structure according to claim 17, wherein the forming, on the substrate, a plurality of repeating units (3) spaced apart in parallel and word lines (2) located between the adjacent repeating units (3) comprises:
forming a plurality of initial active structures (311A) spaced apart in parallel on the substrate, the plurality of initial active structures (311A) extending along a third direction (D), and the third direction (D) intersecting with both the first direction (Y) and the second direction (X);
forming initial isolation structures (312A) and initial sacrificial structures (360A) conformally stacked in gaps between adjacent initial active structures (311A);
patterning the initial active structures (311A), the initial isolation structures (312A), and the initial sacrificial structures (360A) to form intermediate active structures (311B), intermediate isolation structures (312B), intermediate sacrificial structures (360B), and a plurality of isolation grooves, the plurality of isolation grooves extending along the second direction (X);
forming initial isolation units (350A) in the plurality of isolation grooves;
patterning the intermediate active structures (311B), the intermediate isolation structures (312B), the intermediate sacrificial structures (360B), and the initial isolation units (350A) to form a plurality of first repeating units (330) and a plurality of second repeating units (340) alternately arranged in the first direction (Y), isolation units (350) located between any of the first repeating units (330) and second repeating units (340) adjacent thereto, as well as a plurality of word line trenches, wherein each of the plurality of first repeating units (330) comprises a first active structure (331) and a first sacrificial structure (361) arranged side by side in the second direction (X) as well as an encapsulating layer (322) surrounding the first sacrificial structure (361); each of the plurality of second repeating units (340) comprises a second sacrificial structure (362) and a second active structure (342) arranged side by side in the second direction (X) as well as an encapsulating layer (322) surrounding the second sacrificial structure (362); each of the plurality of word line trenches extends along the first direction (Y);
forming the word lines (2) in the plurality of word line trenches; and
removing the first sacrificial structure (361) and the second sacrificial structure (362) to correspondingly form a first air gap structure (332) and a second air gap structure (341).
